# EUROPÄISCHE PATENTSCHRIFT

(11) **EP 1 334 515 B1**
(45) Veröffentlichungstag und Bekanntmachung des Hinweises auf die Patenterteilung: **16.07.2008**
(21) Anmeldenummer: 01996885.8
(22) Anmeldetag: 17.10.2001
(51) Int. Cl.: H01L 21/762

(54) **VERFAHREN ZUR HERSTELLUNG EINES INTEGRIERTEN HALBLEITER-BAUELEMENTS**
METHOD FOR PRODUCING AN INTEGRATED SEMICONDUCTOR COMPONENT
PROCEDE DE FABRICATION D'UN COMPOSANT SEMI-CONDUCTEUR INTEGRE

(30) Priorität: 14.11.2000 DE 10056261
(43) Veröffentlichungstag der Anmeldung: 13.08.2003
(73) Patentinhaber: Infineon Technologies AG, 81669 München (DE)
(72) Erfinder: MOLL, Hans-Peter, 01277 Dresden (DE); WICH-GLASEN, Andreas, 01465 Langebrueck (DE); TRUEBY, Alexander, 01109 Dresden (DE)
(74) Vertreter: Ginzel, Christian
(86) Internationale Anmeldenummer: PCT/EP2001/012034
(87) Internationale Veröffentlichungsnummer: WO 2002/041399

(56) Entgegenhaltungen:
- EP-A- 0 905 756
- US-A- 4 687 682
- US-A- 5 981 353
- US-A- 6 037 018
- US-A- 6 057 207
- US-A- 6 057 210
- US-A- 6 133 114

## Beschreibung

Die Erfindung betrifft ein Verfahren zur Herstellung eines integrierten Halbleiter-Bauelements.

Integrierte Halbleiter-Bauelemente werden durch Bildung integrierter Schaltkreise auf Halbleiterwafern hergestellt. Die integrierten Schaltkreise werden intern und extern leitend mit dem Halbleiterwafer verbunden, wodurch strukturierte leitende Schichten ausgebildet werden, die wiederum durch dielektrische Schichten voneinander getrennt sind. Um eine einwandfreie Funktionsfähigkeit der Bauelemente zu gewährleisten, müssen die einzelnen aktiven Elemente der integrierten Schaltkreise voneinander isoliert werden. Dies wird durch sogenannte Isolationsgräben erreicht, die in dem Halbleiterwafer geformt und anschließend mit einem nichtleitenden Material gefüllt werden (shallow trench isolation, STI). Das Füllen mit nichtleitendem Material geschah bisher üblicherweise durch konforme Abscheidung einer Isolationsschicht, also durch Abscheidung von Isolationsmaterial mit gleicher Geschwindigkeit auf sämtlichen zugänglichen Oberflächen. Dadurch erfolgt die Bildung einer Schicht gleichmäßiger Dicke auf dem HalbleiterBauelement.

In den letzten Jahren hat sich die Komplexität der integrierten Schaltkreise stark vergrößert, während gleichzeitig die Größe der Schaltkreise drastisch abgenommen hat. Aus diesem Grund wurden die zur Trennung der einzelnen aktiven Elemente notwendigen Isolationsgräben mit einem immer größer werdenden Aspektverhältnis geformt. Zur Füllung dieser Isolationsgräben mit großem Aspektverhältnis können aber die klassischen konformen Abscheidungsprozesse nicht mehr angewandt werden, da die Abscheidung von Isolationsmaterial auf den Wänden des Isolationsgrabens dessen Verschluss bewirkt bevor der Isolationsgraben vollständig gefüllt ist. Durch die so entstehenden Hohlräume werdem optimale Isolationseigenschaften verhindert.

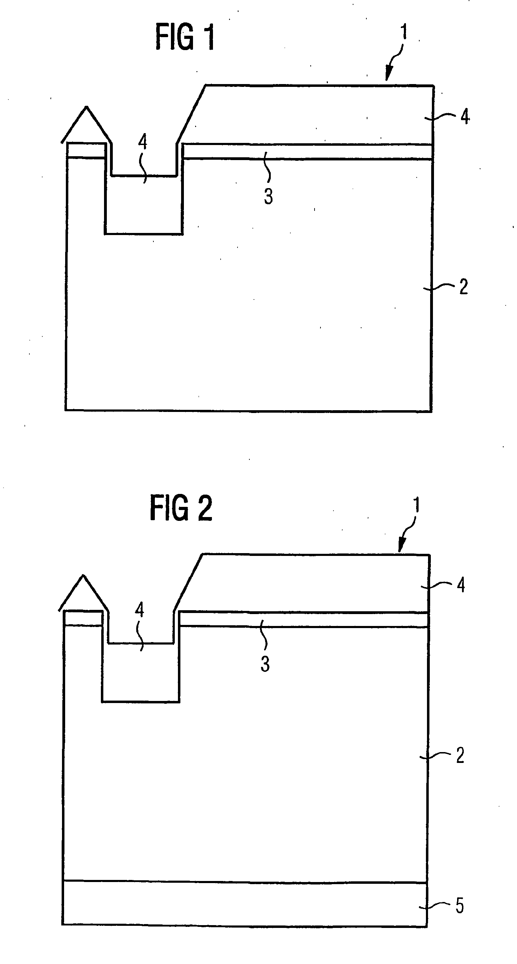

Mit zunehmender Komplexität bei neuen Technologieshrinks und dem damit verbundenen zunehmenden Aspektverhältnis der Isolationsgräben gewannen daher nicht-konforme Füllprozesse zur Füllung der Isolationsgräben an Bedeutung. Bei diesen nicht-konformen Füllprozessen erfolgt die Abscheidung von Isolationsmaterial auf verschiedenen Flächen des Halbleiterbauelements mit unterschiedlicher Geschwindigkeit, wodurch Isolationsschichten unterschiedlicher Dicke auf dem Halbleiterbauelement abgeschieden werden. Da sich das Isolationsmaterial am Boden der Isolationsgräben schneller abscheidet als an den Wänden der Gräben, werden die Isolationsgräben mit dem Isolationsmaterial gefüllt, ohne dass Hohlräume gebildet werden. Die restlichen Strukturen des Halbleiterbauelements werden ebenfalls von einer Isolationsschicht bedeckt (siehe Figur 1).

Derartige Verfahren sind zum Beispiel aus der US5981353, und der US 6037018; und der US6057210 bekannt.

Bei der Anwendung dieser nicht-konformen Füllprozesse tritt das Problem auf, dass keine Versiegelung der Waferrückseite erfolgt. Bei fehlender Rückseitenversiegelung besteht aber die Gefahr, dass bei nachfolgenden thermischen Prozessen Materialien wie z.B. Dotierstoffe aus der Rückseite des Wafers austreten und sich auf dem benachbarten Wafer absetzen, da die Wafer üblicherweise in Rotten stehend den thermischen Prozessen unterzogen werden. Dies kann Einflüsse auf weitere Prozessschritte und auch auf die elektrische Funktionalität der integrierten Schaltung haben. Insbesondere sind Einsatzspannung, Leckströme und GOX-Zuverlässigkeit als Problemquellen zu nennen.

Der vorliegenden Erfindung liegt daher die Aufgabe zugrunde, ein Verfahren zur Herstellung integrierter Halbleiter-Bauelemente bereitzustellen, bei dem optimale Isolationseigenschaften der Isolationsgräben erreicht werden und gleichzeitig eine Versiegelung der Wafer-Rückseite erfolgt.

Diese Aufgabe wird durch das Verfahren zur Herstellung eines integrierten Halbleiter-Bauelements gemäß dem unabhängigen Patentanspruch 1 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Das erfindungsgemäße Verfahren zur Herstellung eines integrierten Halbleiter-Bauelements umfasst die Schritte Formen wenigstens eines Isolationsgrabens, Aufbringen einer ersten Schicht aus einem nicht-leitenden Material durch eine nicht-konforme Abscheidemethode und Aufbringen einer zweiten Schicht aus einem nicht-leitenden Material durch eine konforme Abscheidemethode zumindest auf die Rückseite des Halbleiter-Bauelements.

In dem erfindungsgemäßen Verfahren wird also nach Füllung des Isolationsgrabens durch eine nicht-konforme Abscheidemethode ein zusätzlicher Abscheideschritt durchgeführt. Dieser dient der Versiegelung der Rückseite des Halbleiter-Bauelements. Dadurch wird verhindert, dass in nachfolgenden thermischen Prozessschritten zur Behandlung des Halbleiter-Bauelements aus der Rückseite Materialien wie z.B. Dotierstoffe ausdiffundieren. Die aufgrund des temperaturabhängigen Dampfdrucks dieser Materialen bei erhöhten Temperaturen stärker auftretende Ausdiffusion wird durch die Rückseitenversiegelung verhindert.

Gemäß einer bevorzugten Ausführungsform der vorliegenden Erfindung weist der Isolationsgraben eine Tiefe zwischen 500 und 1000 Nanometer (5000 und 10000 Angstroem) auf, insbesondere eine Tiefe zwischen 600 und 800 Nanometer (6000 und 8000 Angstroem).

Bevorzugt sind daneben Ausführungsformen, bei denen die erste Schicht aus einem nichtleitenden Material in einer Dicke zwischen 100 und 400 Nanometer (1000 und 4000 Angstroem), insbesondere in einer Dicke zwischen 200 und 300 Nanometer (2000 und 3000 Angstroem) aufgetragen wird.

Gemäß ganz besonders bevorzugten Ausführungsformen der vorliegenden Erfindung wird die zweite Schicht aus einem nichtleitenden Material in einer Dicke zwischen 100 und 500 Nanometer (1000 und 5000 Angstroem), insbesondere in einer Dicke zwischen 200 und 400 Nanometer (2000 und 4000 Angstroem) aufgetragen.

Als nicht-konforme Methode zur Abscheidung der ersten Schicht aus nicht-leitendem Material wird die high density plasma chemical vapor deposition (HDP-CVD) oder ein Selox-Verfahren (selective oxide) bevorzugt, während als konforme Methode zur Abscheidung der zweiten Schicht aus nichtleitendem Material die atmospheric pressure thermal chemical vapor deposition (APCVD), die sub-atmospheric pressure thermal chemical vapor deposition (SACVD) oder die low pressure chemical vapor deposition (LPCVD) bevorzugt angewendet werden.

Als nicht-leitendes Material zur Füllung der Isolationsgräben und zur Versiegelung der Rückseite des Halbleiter-Bauelements wird bevorzugt Siliziumoxid verwendet. Als Si-Quelle beim Aufbringen der nicht-leitenden Schichten wird Tetraethylorthosilikat (TEOS) bevorzugt.

Ganz besonders bevorzugt wird eine Ausführungsform der vorliegenden Erfindung gemäß der die durch eine konforme Abscheidemethode aufgebrachte zweite Schicht aus einem nichtleitenden Material auch auf die Vorderseite des Halbleiter-Bauelements aufgebracht wird. Dadurch kann zum einen die Füllung der Isolationsgräben weiter vervollständigt werden und zum anderen wird die topologieabhängige Dicke der Isolationsschicht ausgeglichen.

Gemäß einer ganz besonders bevorzugten Ausführungsform der vorliegenden Erfindung wird als weiterer Schritt nach dem Aufbringen der zweiten Schicht aus einem nicht-leitenden Material ein chemical mechanical polishing (CMP) durchgeführt. Wird die durch die konforme Abscheidemethode aufgebrachte zweite Schicht auch auf der Vorderseite des integrierten Halbleiter-Bauelements aufgebracht, so ergibt sich der besondere Vorteil, dass durch den vorherigen Ausgleich der Dicke der Schicht aus nicht-leitendem Material Polish-Only CMP Technologien angewandt werden können.

Die Erfindung wird nachfolgend anhand der Figuren 1 bis 3 näher dargestellt. Es zeigen:
- Fig. 1: schematisch den Querschnitt eines Halbleiter-Bauelements mit einer ersten durch eine nicht-konforme Abscheidemethode aufgebrachten Schicht aus einem nicht-leitenden Material;
- Fig. 2: schematisch den Querschnitt eines Halbleiter-Bauelements mit einer zweiten durch eine konforme Abscheidemethode auf die Rückseite des Halbleiter-Bauelements aufgebrachten Schicht aus einem nicht-leitenden Material;
- Fig. 3: schematisch den Querschnitt eines Halbleiter-Bauelements mit einer zweiten durch eine konforme Abscheidmethode auch auf die Vorderseite des Halbleiter-Bauelements aufgebrachten Schicht aus einem nichtleitenden Material.

Fig. 1 zeigt schematisch den Querschnitt eines aus dem Stand der Technik bekannten Halbleiter-Bauelements 1 bestehend aus einer Halbleiterschicht 2, einer Padnitrid-Schicht 3 und einer ersten durch eine nicht-konforme Abscheidemethode aufgebrachten Schicht 4 aus einem nichtleitenden Material. Die Rückseite des Halbleiter-Bauelements ist durch die nicht-konforme Abscheidemethode nicht versiegelt.

Fig. 2 zeigt schematisch den Querschnitt eines Halbleiter-Bauelements 1 bestehend aus einer Halbleiterschicht 2, einer Padnitrid-Schicht 3, einer ersten durch eine nicht-konforme Abscheidemethode aufgebrachten Schicht 4 aus einem nicht-leitenden Material und einer zweiten durch eine konforme Abscheidemethode auf die Rückseite des Halbleiter-Bauelements aufgebrachten Schicht 5 aus einem nicht-leitenden Material. Durch den zusätzlichen Abscheideschritt ist auch die Rückseite des Halbleiter-Bauelements versiegelt.

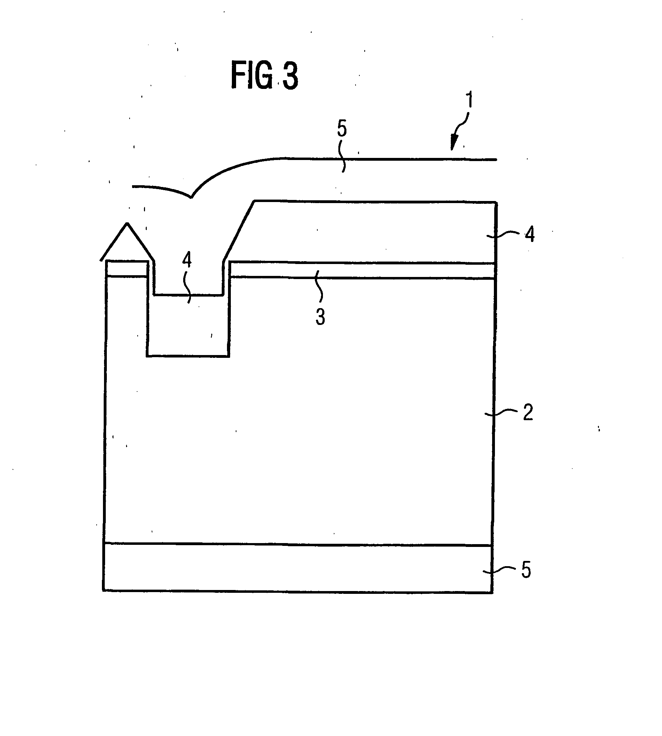

Fig. 3 zeigt schematisch den Querschnitt eines Halbleiter-Bauelements 1 bestehend aus einer Halbleiterschicht 2, einer Padnitrid-Schicht 3, einer ersten durch eine nicht-konforme Abscheidemethode aufgebrachten Schicht 4 aus einem nicht-leitenden Material und einer zweiten durch eine konforme Abscheidemethode aufgebrachten Schicht 5 aus einem nicht-leitenden Material. Die Schicht 5 ist in dieser Ausführungsform nicht nur auf der Rückseite des integrierten Halbleiter-Bauelements aufgebracht, sondern auch auf dessen Vorderseite. Durch den zusätzlichen Abscheideschritt wird neben der versiegelung der Rückseite des Halbleiter-Bauelements auch die Füllung der Isolationsgräben weiter vervollständigt und die topologieabhängige Dicke der Isolationsschicht ausgeglichen.

## Patentansprüche

1. Verfahren zur Herstellung eines integrierten Halbleiter-Bauelements (1) umfassend die Schritte
- eine Halbleiterschicht (2) mit einer Vorder- und einer Rückseite wird bereitgestellt,
- wenigstens ein Isolationsgraben wird in der Vorderseite der Halbleiterschicht (2) geformt,
- eine erste Schicht (4) aus einem nicht-leitenden Material wird durch eine nicht-konforme Abscheidemethode auf die Vorderseite der Halbleiterschicht (2) aufgebracht, **dadurch gekennzeichet, daß**
- anschließend eine zweite Schicht (5) aus nicht-leitendem Material durch eine konforme Abscheidemethode auf die Vorder- und die Rückseite der Halbleiterschicht (2) aufgebracht wird, wobei
- als nicht-leitende Materialen Siliziumoxid verwendet wird.

2. Verfahren nach Anspruch 1,
**dadurch gekennzeichnet, dass** der Isolationsgraben eine Tiefe zwischen 500 und 1000 Nanometer (5000 und 10000 Angstroem) aufweist.

3. verfahren nach Anspruch 2,
**dadurch gekennzeichnet, dass** der Isolationsgraben eine Tiefe zwischen 600 und 800 Nanometer (6000 und 8000 Angstroem) aufweist.

4. verfahren nach einem der vorhergehenden Ansprüche,
**dadurch gekennzeichnet, dass** die erste Schich (4) aus einem nichtleitenden Material eine Dicke zwischen 100 und 400 Nanometer (1000 und 4000 Angstroem) aufweist.

5. Verfahren nach Anspruch 4,
**dadurch gekennzeichnet, dass** die erste Schicht (4) aus einem nichtleitenden Material eine Dicke zwischen 200 und 300 Nanometer (2000 und 3000 Angstroem) aufweist.

6. Verfahren nach einem der vorhergehenden Ansprüche,
**dadurch gekennzeichnet, dass** die zweite Schicht (5) aus einem nichtleitenden Material eine Dicke zwischen 100 und 500 Nanometer (1000 und 5000 Angstroem) aufweist.

7. Verfahren nach Anspruch 6,
**dadurch gekennzeichnet, dass** die zweite Schicht (5) aus einem nichtleitenden Material eine Dicke zwischen 200 und 400 Nanometer (2000 und 4000 Angstroem) aufweist.

8. Verfahren nach einem der vorhergehenden Ansprüche,
**dadurch gekennzeichnet, dass** als nicht-konforme Methode zur Abscheidung der ersten Schicht (4) aus nicht-leitendem Material high density plasma chemical vapor deposition (HDP-CVD) oder ein Selox-Verfahren angewendet wird.

9. Verfahren nach einem der vorhergehenden Ansprüche,
**dadurch gekennzeichnet, dass** als konforme Methode zur Abscheidung der zweiten Schicht (5) aus nicht-leitendem Material atmospheric pressure thermal chemical vapor deposition (APCVD), sub-atmospheric pressure thermal chemical vapor deposition (SACVD) oder low pressure LPCVD angewendet wird.

10. Verfahren nach Anspruch 9,
**dadurch gekennzeichnet, dass** als Si-Quelle beim Aufbringen der nicht-leitenden Schichten Tetraethylorthosilikat (TEOS) verwendet wird.

11. Verfahren nach einem der vorherigen Ansprüche,
**dadurch gekennzeichnet, dass** als weiterer Schritt nach dem Aufbringen der zweiten Schicht (5) aus einem nicht-leitenden Material ein chemical mechanical polishing (CMP) durchgeführt wird.

## Claims

1. Method for fabricating an integrated semiconductor component (1), comprising the following steps:
- a semiconductor layer (2) having a front surface and a back surface is provided,
- at least one isolation trench is formed in the front surface of the semiconductor layer (2),
- a first layer (4) of a nonconductive material is applied to the front surface of the semiconductor layer (2) using a nonconformal deposition method, **characterized in that**
- a second layer (5) of a nonconductive material is subsequently applied by a conformal deposition method to the front surface and the back surface of the semiconductor layer (2),
- the nonconductive materials used being silicon oxide.

2. Method according to Claim 1, **characterized in that** the isolation trench is between 500 and 1000 nanometers (5000 and 10,000 angstrom) deep.

3. Method according to Claim 2, **characterized in that** the isolation trench is between 600 and 800 nanometers (6000 and 8000 angstrom) deep.

4. Method according to one of the preceding Claims, **characterized in that** the first layer (4) made from a non-conductive material is between 100 and 400 nanometers (1000 and 4000 angstrom) thick.

5. Method according to Claim 4, **characterized in that** the first layer (4) made from a nonconductive material is between 200 and 300 nanometers (2000 and 3000 angstrom) thick.

6. Method according to one of the preceding Claims, **characterized in that** the second layer (5) made from a nonconductive material is between 100 and 500 nanometers (1000 and 5000 angstrom) thick.

7. Method according to Claim 6, **characterized in that** the second layer (5) made from a nonconductive material is between 200 and 400 nanometers (2000 and 4000 angstrom) thick.

8. Method according to one of the preceding Claims, **characterized in that** high-density plasma chemical vapor deposition (HDP-CVD) or a Selox process is used as the nonconformal method for the deposition of the first layer (4) of nonconductive material.

9. Method according to one of the preceding Claims, **characterized in that** atmospheric pressure thermal chemical vapor deposition (APCVD), subatmospheric pressure thermal chemical vapor deposition (SACVD) or low pressure chemical vapor deposition (LPCVD) is used as the conformal method for deposition of the second layer (5) of non-conductive material.

10. Method according to Claim 9, **characterized in that** the Si source used during the application of the nonconductive layers is tetraethyl orthosilicate (TEOS).

11. Method according to one of the preceding Claims, **characterized in that** chemical mechanical polishing (CMP) is carried out as a further step after the application of the second layer (5) of a nonconductive material.

## Revendications

1. Procédé de production d'un composant ( 1 ) à semiconducteur intégré, comprenant les stades dans lesquels
- on se procure une couche ( 2 ) semi-conductrice ayant une face avant et une face arrière,
- on forme au moins un sillon d'isolation dans la face avant de la couche ( 2 ) semi-conductrice,
- on dépose, par un procédé de dépôt non conforme, une première couche ( 4 ) en un matériau non conducteur sur la face avant de la couche ( 2 ) conductrice, **caractérisé en ce qu'**ensuite
- on dépose, par un procédé de dépôt conforme, une deuxième couche ( 5 ) en un matériau non conducteur sur la face avant et sur la face arrière de la couche ( 2) semi-conductrice, dans lequel
- on utilise de l'oxyde de silicium comme matériau non conducteur.

2. Procédé suivant la revendication 1,
**caractérisé en ce que**
le sillon d'isolation a une profondeur comprise entre 500 et 1000 nanomètres ( 5000 et 10 000 angströms ).

3. Procédé suivant la revendication 2,
**caractérisé en ce que**
le sillon d'isolation a une profondeur comprise entre 600 et 800 nanomètres ( 6000 et 8000 angströms ).

4. Procédé suivant l'une des revendications précédentes,
**caractérisé en ce que**
la première couche ( 4 ) en un matériau non conducteur a une épaisseur comprise entre 100 et 400 nanomètres ( 1000 et 4000 angströms ).

5. Procédé suivant la revendication 4
**caractérisé en ce que**
la première couche ( 4 ) en un matériau non conducteur a une épaisseur comprise entre 200 et 300 nanomètres ( 2000 et 3000 angströms ).

6. Procédé suivant l'une des revendications précédentes,
**caractérisé en ce que**
la deuxième couche ( 5 ) en un matériau non conducteur a une épaisseur comprise entre 100 et 500 nanomètres ( 1000 et 5000 angströms ).

7. Procédé suivant la revendication 6,
**caractérisé en ce que**
la deuxième couche ( 5 ) en un matériau non conducteur a une épaisseur comprise entre 200 et 400 nanomètres ( 2000 et 4000 angströms ).

8. Procédé suivant l'une des revendications précédentes,
**caractérisé en ce que**
l'on utilise comme procédé non conforme de dépôt de la première couche ( 4 ) en matériau non conducteur un dépôt chimique en phase vapeur au plasma à grande densité ( HDP-CVD ) ou un procédé Selox.

9. Procédé suivant l'une des revendications précédentes,
**caractérisé en ce que**
comme procédé conforme de dépôt de la deuxième couche ( 5 ) en matériau non conducteur, on utilise un dépôt chimique en phase vapeur thermique à la pression atmosphérique ( APCVD ), un dépôt chimique en phase vapeur thermique à une pression inférieure à la pression atmosphérique ( SACVD ) ou un LPCVD basse pression.

10. Procédé suivant la revendication 9,
**caractérisé en ce que**
l'on utilise de l'orthosilicate de tétraéthyle ( TEOS ) comme source de Si lors du dépôt des couches non conductrices.

11. Procédé suivant l'une des revendications précédentes,
**caractérisé en ce que**
l'on effectue, comme autre stade, après le dépôt de la deuxième couche ( 5 ) en un matériau non conducteur, un polissage chimiomécanique ( CMP ).
